# EUROPÄISCHE PATENTSCHRIFT

(11) **EP 1 336 245 B1**
(45) Veröffentlichungstag und Bekanntmachung des Hinweises auf die Patenterteilung: **15.09.2004**
(21) Anmeldenummer: 01996922.9
(22) Anmeldetag: 13.11.2001
(51) Int. Cl.: H03B 5/12

(54) **OSZILLATORSCHALTUNG**
OSCILLATOR CIRCUIT
MONTAGE OSCILLATEUR

(30) Priorität: 17.11.2000 DE 10056943
(43) Veröffentlichungstag der Anmeldung: 20.08.2003
(73) Patentinhaber: Infineon Technologies AG, 81669 München (DE)
(72) Erfinder: TRAUB, Johann, 89415 Lauingen (DE)
(74) Vertreter: Epping Hermann & Fischer
(86) Internationale Anmeldenummer: PCT/DE2001/004249
(87) Internationale Veröffentlichungsnummer: WO 2002/041487

(56) Entgegenhaltungen:
- EP-A- 0 347 993
- US-A- 5 850 595
- STEYAERT M ET AL: "1.1 GHz oscillator using bondwire inductance" ELECTRONICS LETTERS, IEE STEVENAGE, GB, Bd. 30, Nr. 3, 3. Februar 1994 (1994-02-03), Seiten 244-245, XP006000151 ISSN: 0013-5194

## Beschreibung

Die vorliegende Erfindung betrifft eine Oszillatorschaltung.

Beispielsweise im Mobilfunk werden vollintegrierte spannungsgesteuerte Oszillatoren VCO, Voltage Controlled Oscillator, im Gigahertz-Bereich eingesetzt, an die hohe Anforderungen bezüglich Phasenrauschen gestellt werden. Zugleich besteht der Wunsch nach integrierten Schaltungen mit möglichst geringem Platzbedarf, Chips mit möglichst geringer Anzahl von Anschluß-Pins sowie guten Eigenschaften bezüglich elektromagnetischer Verträglichkeit.

Integrierte VCO können beispielsweise als LC-Oszillatoren realisiert sein. Während die Integration der Resonanzkreiskapazitäten für derartige VCO verhältnismäßig einfach und mit geringem Chipflächenbedarf realisierbar ist, ist die Integration beziehungsweise Realisierung der Resonatorinduktivitäten verhältnismäßig aufwendig. Mögliche Realisierungen von Induktivitäten sind beispielsweise spiralförmige Anordnungen, welche beispielsweise auf einer integrierten Schaltung oder Leiterplatte angeordnet sind, aktive Induktivitäten, welche mit einer Kapazität und einer daran angeschlossenen Gyratorschaltung realisierbar sind, sowie die Nutzung eigentlich parasitärer induktiver Eigenschaften von Bonddrähten. Als Faustformel gilt dabei, daß die Induktivität eines Bonddrahtes ca. 1 nH pro mm beträgt.

Der Vorteil von Bonddrähten als Induktivitäten in LC-Oszillatoren liegen dabei in der erreichbaren hohen Güte. Bei den Bonddrähten unterscheidet man Bonden von Pads, das heißt Kontaktstellen auf einem Chip, zu einem Pin, von einem Pad zu einem Trägerelement des Chips sowie von einem zu einem anderen Pad des Chips.

In der Druckschrift "A 1.8-GHz CMOS Low-Phase-Noise Voltage-Controlled Oscillator with Prescaler", Jan Craninckx, M. Steyaert, IEEE Journal on Solid-State Circuits, Vol. 30, No. 12, 1995, Seiten 1474 bis 1482, ist die Implementierung eines VCO in einer PLL(Phase Locked Loop, Phasenregelschleife) angegeben. Der VCO ist dabei als abstimmbarer LC-Oszillator ausgeführt. Als Induktivitäten im LC-Oszillator sind Bonddraht-Induktivitäten vorgesehen. Diese Bonddraht-Induktivitäten sind dabei von einer Kontaktstelle des Chips zu einer anderen Kontaktstelle des Chips ausgeführt, was einen sehr großen Chip-Flächenbedarf erfordert.

Aus der Druckschrift "A packaged 1.1-GHz CMOS VCO with Phase Noise of -126 dBc/Hz at a 600-kHz Offset", Hung et al, IEEE Journal on Solid-State Circuits, Vol. 35, No. 1, 2000, Seiten 100 bis 103, ist ebenfalls ein spannungsgesteuerter Oszillator bekannt, bei dem zur Realisierung der Induktivität des LC-Oszillators eine Kombination eines auf dem Chip integrierten spiralförmigen induktiven Elementes, mehrerer Bonddrähte vom Chip zu Pins, sowie Zwischenpins vorgesehen ist. Hierfür sind vier zusätzliche Pins am Chip erforderlich, zudem ergibt sich ein größerer Chipflächenbedarf sowie unerwünschte Signalkopplungen mit dem Gehäuse.

In dem Dokument "A 1.3 GHz Low-Phase Noise Fully Tuneable CMOS LC VCO", F. Svelto et al, IEEE Journal on Solid-State Circuits, Vol. 35, No. 3, 2000, Seiten 356 bis 361, ist ebenfalls ein spannungsgesteuerter LC-Oszillator angegeben. Auch hier sind Bonddraht-Induktivitäten vorgesehen, welche zusätzlich zu integrierten Induktivitäten die Induktivitäten des LC-Kerns ergeben. Auch diese Kombination führt zu einem hohen Chipflächen- und Pinbedarf der Anordnung.

Aufgabe der vorliegenden Erfindung ist es, eine Oszillatorschaltung anzugeben, die einen geringen Chipflächenbedarf, eine hohe Güte sowie gute Phasenrauscheigenschaften aufweist.

Erfindungsgemäß wird die Aufgabe mit einer Oszillatorschaltung gelöst, aufweisend
- einen Oszillatorkern mit einer ersten Kapazität und einer zweiten Kapazität, und mit einer ersten Induktivität und einer zweiten Induktivität, die in einem ersten Schaltungsknoten mit je einer Kapazität verbunden sind und
- einen Entdämpfungsverstärker, der mit dem Oszillatorkern und mit einer Versorgungsspannungsquelle, die einen Versorgungs- und einen Bezugspotentialanschluß hat, gekoppelt ist,
- wobei Oszillatorkern und Entdämpfungsverstärker auf einem Halbleiterplättchen, das eine Vorder- und Rückseite hat, integriert sind und
- die erste und zweite Induktivität jeweils als Bonddraht ausgebildet sind und dabei jeweils mit einem ersten Anschluß mit an den ersten Schaltungsknoten angeschlossenen Kontaktstellen und mit einem zweiten Anschluß mit einem Träger, auf dem das Halbleiterplättchen mit seiner Rückseite befestigt ist, verbunden sind.

Das Halbleiterplättchen kann als Chip ausgebildet sein. Der Träger kann beispielsweise ein Teil eines Leadframe sein, auf dem das Halbleiterplättchen angeordnet ist. Auf dem Träger können außerhalb des Halbleiterplättchens Leiterbahnen verlaufen, mit denen die zweiten Anschlüsse der Bonddrähte verbunden sein können. Der Träger kann eine Leiterplatte sein. Der Träger kann ein metallischer Träger sein. Der Träger kann ein weiteres Halbleiterplättchen sein. Der Träger kann mit dem Halbleiterplättchen, insbesondere mit dessen Substrat, großflächig elektrisch und/oder thermisch leitfähig verbunden sein.

Dabei sind keine zusätzlichen Bonddrähte erforderlich, da der Oszillatorkern mit der zumindest einen Induktivität ohnehin mit Versorgungs- und Bezugspotentialanschluß gekoppelt sein kann. Zudem sind keine zusätzlichen Pins am Chip erforderlich, da die Bonddraht-Induktivitäten nicht an Pins, sondern auf dem Träger angeschlossen sind, das heißt von einer Kontaktstelle auf dem Halbleiterplättchen, auch als Pad bezeichnet, zu einem Trägerelement, auch als Die Pad bezeichnet, auf dem das Halbleiterplättchen befestigbar ist, führen.

Dieses Trägerelement oder Leadframe ist üblicherweise elektrisch mit dem Halbleitersubstrat eines Halbleiterplättchens verbunden, beispielsweise mit einem Leitkleber. Handelt es sich dabei um einen Chip mit p-Substrat, so sind Bonddrähte, welche auf dem Trägerelement elektrisch leitend angeschlossen sind, unmittelbar mit dem Bezugspotentialanschluß der Oszillatorschaltung verbunden, wenn wie in einer bevorzugten Ausführungsform der Erfindung das Halbleiterplättchen mit seiner Rückseite auf dem Leadframe angeordnet ist. Dabei können alle Bauelemente der Oszillatorschaltung, umfassend Oszillatorkern ohne Induktivitäten sowie Entdämpfungsverstärker, vollständig und monolithisch auf dem Chip integriert sein.

Die Bonddrähte stellen bei der Oszillatorschaltung für den LC-Oszillatorkern den induktiven Anteil zur Verfügung, der eigentlich bei Bonddrähten ein parasitärer induktiver Anteil ist. Diese parasitäre Induktivität der ohnehin zum Anschließen der Oszillatorschaltung an Bezugs- und Versorgungspotential erforderlichen Bonddrähte wird demnach gemäß dem vorliegenden Prinzip in vorteilhafter Weise genutzt.

In einer bevorzugten Ausführung der Erfindung sind erste und zweite Induktivität mit ihren zweiten Anschlüssen jeweils an den Bezugspotentialanschluß der Oszillatorschaltung angeschlossen.

In einer weiteren, bevorzugten Ausführung der Erfindung hat der Chip ein p-dotiertes Substrat. Die Bonddrähte können dann an Pads auf der aktiven Vorderseite des Chips angeschlossen sein, während der Chip mit seiner Rückseite auf dem Leadframe befestigt sein kann.

Die Befestigung des Chips auf dem Leadframe erfolgt bevorzugt mit einem Klebstoff. Dieser Klebstoff kann elektrisch und/oder thermisch leitfähig sein.

In einer weiteren, bevorzugten Ausführungsform der Oszillatorschaltung ist zur Kopplung von Oszillatorkern und Entdämpfungsverstärker eine Resonanztransformationsschaltung vorgesehen, welche ein Paar von an den ersten Schaltungsknoten angeschlossenen Koppelkapazitäten umfaßt, die in einem zweiten Schaltungsknoten an je eine weitere Induktivität angeschlossen sind.

An den zweiten Schaltungsknoten ist dabei der Entdämpfungsverstärker angeschlossen. Die Resonanztransformation bringt zum einen den Vorteil, daß der Oszillatorkern, der abstimmbar ausgeführt sein kann, einen niederohmigen Schaltungsteil mit einem Resonator hoher Güte realisiert, während mit Koppelkapazitäten und weiteren Induktivitäten, welche integriert sein können, ein Serienschwingkreis gebildet ist, der eine Resonanztransformation vornimmt zwischen dem niederohmigen ersten Schaltungsknoten und dem hochohmigen zweiten Schaltungsknoten. Dies hat den Vorteil, daß der Entdämpfungsverstärker, der beispielsweise ein Differenzverstärker sein kann, an einen hochohmigen Schaltungsknoten angeschlossen ist.

Der Resonator im Oszillatorkern kann dabei als Parallelresonator abstimmbar ausgeführt sein. Dieser kann den integrierten Serienschwingkreis innerhalb seiner hohen Bandbreite frequenzmäßig führen. Die weitere Induktivität kann direkt an den Versorgungspotentialanschluß angeschlossen sein, der Entdämpfungsverstärker kann, beispielsweise über eine Stromquelle, an Bezugspotentialanschluß angeschlossen sein.

Die Resonanztransformation bewirkt weiter, daß am zweiten Schaltungsknoten eine höhere Amplitude eines oszillierenden Signals auftritt als am ersten Schaltungsknoten. Dort hat die geringere Schwingungsamplitude den Vorteil, daß die Kapazitäten des Oszillatorkerns, welche beispielsweise als abstimmbare Dioden ausgeführt sein können, aufgrund der geringen Amplitude nicht in einen leitenden Zustand treten.

Schließlich ermöglicht die beschriebene Oszillatorschaltung mit Resonanztransformationsschaltung, daß trotz der Induktivitäten des Oszillatorkerns, welche unmittelbar an Bezugspotentialanschluß angeschlossen sein können, NMOS- statt PMOS-Transistoren oder NPN- statt PNP-Transistoren im Entdämpfungsverstärker eingesetzt sein können. N-Kanal-MOS-Transistoren haben gegenüber P-Kanal-Transistoren den Vorteil der höheren Steilheit und damit einer größeren Verstärkung bei kleinerer Bauform. Bei bipolarer Schaltungsrealisierung, die ebenfalls möglich ist, haben npn- gegenüber pnp-Transistoren, ebenso wie NMOS- gegenüber PMOS-Transistoren bessere Hochfrequenzeigenschaften.

In einer weiteren vorteilhaften Ausführungsform der vorliegenden Erfindung weist der Entdämpfungsverstärker zumindest einen NMOS-Transistor auf. Ist der Entdämpfungsverstärker als Differenzverstärker ausgeführt, so können zwei NMOS-Transistoren, welche galvanisch kreuzgekoppelt sein können, vorgesehen sein. Die NMOS-Transistoren können dabei mit je einem Anschluß ihrer gesteuerten Strecken miteinander und über eine Stromquelle mit einem Bezugspotentialanschluß verbunden sein.

In einer weiteren bevorzugten Ausführungsform der Oszillatorschaltung sind die Kapazitäten im Oszillatorkern als Varaktordioden mit spannungsabhängigem Kapazitätswert ausgeführt. Diesen abstimmbaren Dioden kann dabei eine Steuerspannung zuführbar sein, beispielsweise an ihrem Anodenanschluß, mit der die Resonanzfrequenz des LC-Oszillatorkerns unter Bildung eines VCO einstellbar ist.

In einer weiteren bevorzugten Ausführungsform der Erfindung sind die Varaktordioden galvanisch über eine Kontaktstelle je an jeweils eine Induktivität angeschlossen. Die Kontaktstelle kann dabei ein Pad sein, an dem der Kathodenanschluß der Varaktordiode mit Bonddrähten elektrisch kontaktierbar ist.

In einer weiteren vorteilhaften Ausführungsform der vorliegenden Erfindung sind der Oszillatorkern und die Resonanztransformationsschaltung in symmetrischer Schaltungstechnik ausgebildet zur Führung von Differenzsignalen und der Entdämpfungsverstärker zum Bereitstellen einer negativen Impedanz ist ein Differenzverstärker mit zwei in einer galvanischen Verbindung kreuzgekoppelten Transistoren. In einer derartigen symmetrischen Oszillatorschaltung sind Induktivität und Kapazität im Oszillatorkern jeweils doppelt vorgesehen, ebenso wie Koppelkapazität und weitere Induktivität. Der als Differenzverstärker ausgeführte Entdämpfungsverstärker weist zwei kreuzgekoppelte Transistoren auf, an deren Source- beziehungsweise Emitteranschlüssen eine Stromquelle gegen Bezugspotentialanschluß angeschlossen sein kann. Die symmetrische Ausführung der Oszillatorschaltung hat unter anderem den Vorteil höherer Signalamplituden und damit besserer Rauscheigenschaften sowie besserer elektromagnetischer Verträglichkeit, insbesondere Störfestigkeit.

Die Kreuzkopplung im Differenzverstärker kann dabei anstelle einer galvanischen Kopplung auch eine induktive oder eine kapazitive Kopplung sein.

Abgesehen von den Induktivitäten des Oszillatorkerns, die als Bonddraht ausgeführt sind, können alle übrigen elektrischen Bauelemente der Oszillatorschaltung monolithisch in einem Chip vollintegriert sein.

Weitere Einzelheiten der Erfindung sind in den Unteransprüchen angegeben.

Die Erfindung wird nachfolgend an einem Ausführungsbeispiel anhand der Zeichnungen näher erläutert. Es zeigen:
- Figur 1: ein Prinzipschaltbild eines Ausführungsbeispiels einer erfindungsgemäßen Oszillatorschaltung mit symmetrischem Schaltungsaufbau,
- Figur 2: eine perspektivische Darstellung einer Implementierung der Oszillatorschaltung von Figur 1 auf einem Chip mit Leadframe und
- Figur 3: einen Querschnitt durch Chip und Leadframe von Figur 2.

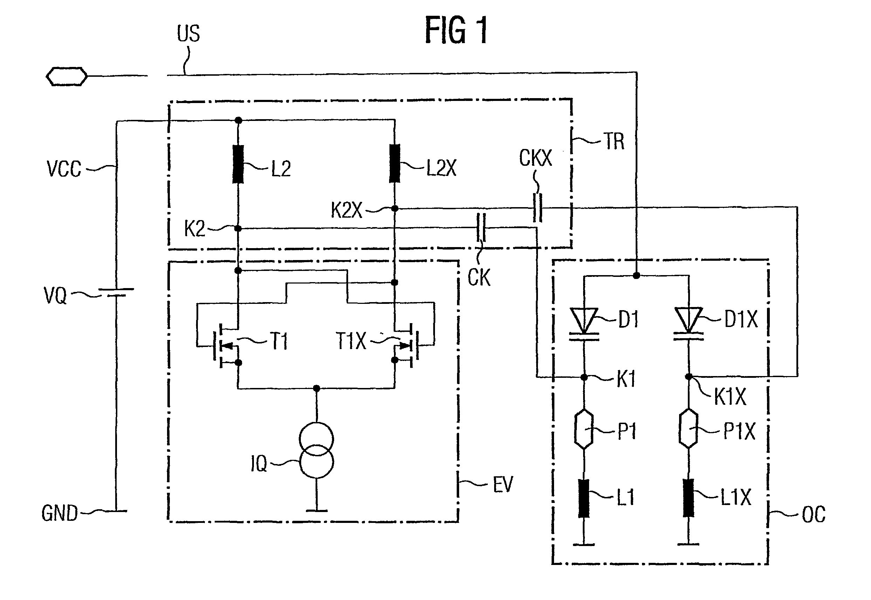

Figur 1 zeigt eine Oszillatorschaltung mit einem Oszillatorkern OC, einer Resonanztransformationsschaltung TR sowie einem Entdämpfungsverstärker EV. Zur Abstimmung des Oszillators ist eine Steuerspannung US vorgesehen, welche dem Oszillatorkern OC zuführbar ist. Schließlich weist die Oszillatorschaltung eine Spannungsquelle VQ auf, welche einerseits an einen Versorgungspotentialanschluß VCC und andererseits an einen Bezugspotentialanschluß GND angeschlossen ist und die Oszillatorschaltung mit Versorgungsspannung versorgt.

Im einzelnen umfaßt der Oszillatorkern eine Kapazität D1 sowie eine Kapazität D1X, welche als Varaktor- oder Kapazitätsdioden ausgeführt und anodenseitig miteinander verbunden sind. An diesem anodenseitigen Verbindungsknoten der Kapazitäten D1, D1X ist die Steuerspannung US zuführbar. Kathodenseitig ist an den Kapazitäten D1, D1X jeweils eine Kontaktstelle P1, P1X über einen ersten Schaltungsknoten K1, K1X angeschlossen. An die Kontaktstelle P1, P1X ist mit je einem Anschluß je eine als Bonddraht ausgeführte Induktivität L1, L1X angeschlossen, welche mit ihrem freien Anschluß mit dem Bezugspotentialanschluß GND verbunden ist. Insgesamt ist damit der Oszillatorkern OC ein abstimmbarer Parallelresonator mit integrierten Varaktordioden D1, D1X sowie mit Bonddraht-Induktivitäten L1, L1X.

An den ersten Schaltungsknoten K1, K1X ist eine Resonanztransformationsschaltung TR angeschlossen, welche zwei weitere Induktivitäten L2, L2X umfaßt, welche an je einem Anschluß miteinander verbunden sowie mit dem Versorgungspotentialanschluß verbunden sind, und welche an ihren anderen Anschlüssen einen zweiten Schaltungsknoten K2, K2X bilden. Erster und zweiter Schaltungsknoten K1, K1X; K2, K2X sind dabei über je eine Koppelkapazität CK, CKX miteinander gekoppelt. Die Schaltungsknoten K1, K1X; K2, K2X sind dabei symmetrisch ausgeführt.

Ein Entdämpfungsverstärker EV, welcher als Differenzverstärker ausgeführt ist, ist an den zweiten Schaltungsknoten K2, K2X sowie an den Bezugspotentialanschluß GND angeschlossen. Der Differenzverstärker umfaßt zwei galvanisch über Kreuz gekoppelte Transistoren, T1, T1X, welche NMOS-Transistoren sind. An die Source-Anschlüsse der Transistoren T1, T1X, welche miteinander verbunden sind, ist eine Stromquelle IQ angeschlossen, welche mit ihrem freien Anschluß an den Bezugspotentialanschluß GND angeschlossen ist.

Die Resonanztransformationsschaltung TR ist im Gegensatz zum als Parallelresonator ausgelegten Oszillatorkern OC als Serienresonator ausgeführt. Der Oszillatorkern OC weist am ersten Schaltungsknoten K1, K1X eine verhältnismäßig geringe Schwingungsamplitude auf, welche somit ein Leitendwerden der Kapazitätsdioden D1, D1X verhindert. Der erste Schaltungsknoten K1, K1X ist dabei ein niederohmiger Schaltungsknoten. Die Koppelkapazitäten CK, CKX führen mit den weiteren Induktivitäten L2, L2X, welche einen integrierten Serienschwingkreis bilden, eine Resonanztransformation durch, welche dazu führt, daß am zweiten Schaltungsknoten K2, K2X eine große Schwingamplitude auftritt. Dabei bildet der zweite Schaltungsknoten K2, K2X einen hochohmigen Schaltungsknoten. An diesen zweiten Schaltungsknoten K2, K2X kann aufgrund seiner Hochohmigkeit ein herkömmlicher, für VCO geeigneter Verstärker EV betrieben werden, wie in der Figur 1 gezeigt. Die Besonderheit dabei ist, daß trotz des abstimmbaren Oszillatorkerns OC, der unmittelbar mit dem Bezugspotentialanschluß verbunden ist, ein Entdämpfungsverstärker mit NMOS-Transistoren verwendbar ist. NMOS-Transistoren haben gegenüber PMOS-Transistoren den Vorteil der höheren Steilheit und damit der größeren Verstärkung. Die Hochohmigkeit des Resonanzwiderstandes am zweiten Schaltungsknoten K2, K2X ermöglicht ein geringes Phasenrauschen der Anordnung.

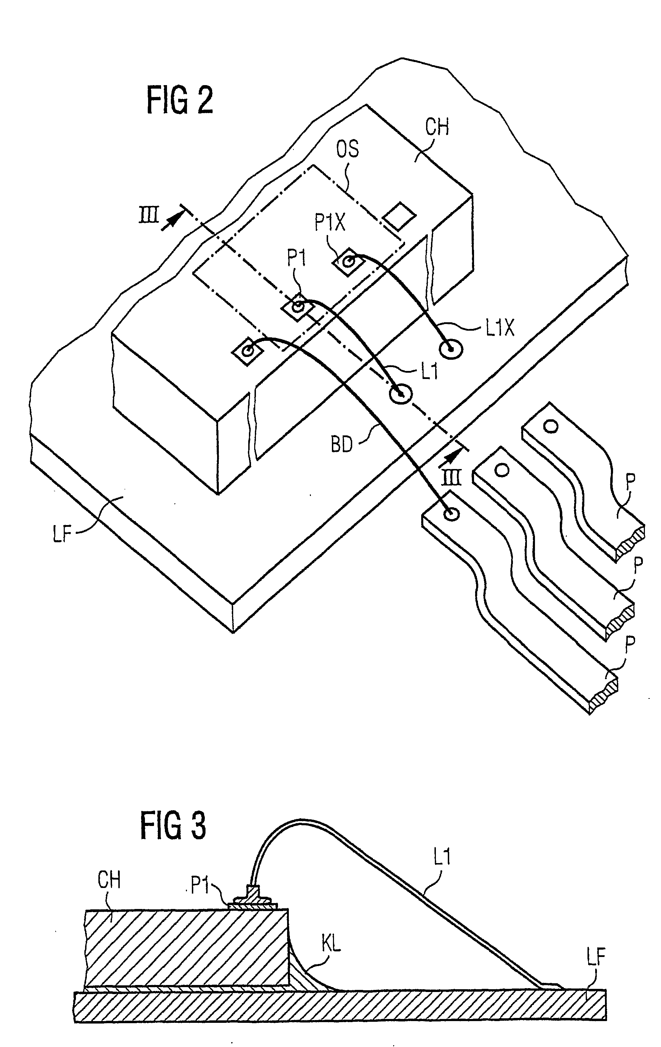

Figur 2 zeigt die Oszillatorschaltung von Figur 1 schematisch. Der Chip CH ist auf einem Leadframe LF rückseitig befestigt. An seiner aktiven Vorderseite weist der Chip CH Kontaktstellen P1, P1X auf. Von diesen Kontaktstellen P1, P1X sind Bonddrähte L1, L1X, welche als Induktivitäten im Resonator des Oszillatorkerns dienen, zum Leadframe LF geführt. Die Kontaktierung des Chips CH zu Pins P kann mit Bonddrähten BD in üblicher Weise erfolgen. Die Anordnung gemäß Figur 2 kann in bekannter Weise mit Kunststoff umspritzt oder mit einer Vergußmasse vergossen sein.

Bis auf die Bonddraht-Induktivitäten L1, L1X sind alle in Figur 1 gezeigten Schaltungsteile der Oszillatorschaltung OS vollständig auf einem Chip CH monolithisch integriert. Bei üblichen Halbleiterprozessen ist das Chipsubstrat ein p-dotiertes Substrat, was gleichbedeutend damit ist, daß ein Substratanschluß des Chips stets der negative Versorgungsspannungsanschluß, hier folglich der Bezugspotentialanschluß GND, ist. Das Leadframe LF wird gelegentlich als Die-Pad bezeichnet. Die Induktivitäten L1, L1X sind nun als je ein Bonddraht ausgeführt, der einerseits mit der Kontaktstelle P1 beziehungsweise P1X und andererseits mit dem Leadframe, das heißt mit dem Bezugspotentialanschluß GND, verbunden ist.

Figur 3 zeigt eine mögliche Ausbildung der Bonddraht-Induktivitäten L1, L1X anhand eines Querschnitts durch die Anordnung von Figur 2. Dabei ist der Chip CH rückseitig mit einem leitenden Klebstoff KL auf dem Leadframe LF befestigt.

An einer Kontaktstelle P1 an der Chip-Vorderseite ist ein Bonddraht L1 befestigt, welcher mit seinem freien Ende auf dem Leadframe LF befestigt ist. Die Struktur des Leadframe LF gewährleistet dabei eine elektrische Verbindung der auf ihm befestigten Anschlüsse der Bonddrähte L1, L1X miteinander und über den Leitkleber KL mit dem Substratanschluß oder Rückseitenanschluß des Chips CH.

Die beschriebene Oszillatorschaltung ist für Anwendungen im Gigahertz-Bereich geeignet und weist ein geringes Phasenrauschen auf.

Der Differenzverstärker im Entdämpfungsverstärker EV kann anstelle der beschriebenen NMOS-Transistoren ebenso in Bipolar-Technik mit NPN-Transistoren aufgebaut sein.

Die Bonddraht-Induktivitäten L1, L1X weisen eine hohe Güte auf. Derartige Bonddrähte von Kontaktstellen (Pads) zu einem Leadframe oder Die-Pad werden gelegentlich auch als Boden-Bonds, Down-Bonds oder Die-Bonds bezeichnet.

Die Besonderheit bei vorliegender Oszillatorschaltung ist, daß trotz der unmittelbar an Bezugspotential angeschlossenen Bonddraht-Induktivitäten L1, L1X dennoch die hochfrequenzmäßig und verstärkungsmäßig günstigeren NMOS- beziehungsweise NPN-Transistoren in einem herkömmlichen Differenzverstärker zum Entdämpfen des Oszillators einsetzbar sind.

Dabei führt der abstimmbare Resonator im Oszillatorkern OC den integrierten Serienschwingkreis CK, CKX, L2, L2X bezüglich der Frequenz innerhalb seiner hohen Bandbreite.

Die Verwendung anderer Entdämpfungsverstärker als der gezeigte, beispielsweise mit nicht galvanisch kreuzgekoppelten sondern induktiv oder kapazitiv kreuzgekoppelten Transistoren, liegen dabei im Rahmen der Erfindung.

### Bezugszeichenliste

- BD: Bonddraht
- CH: Chip
- CK, CKX: Koppelkapazität
- D1, D1X: Kapazität
- EV: Entdämpfungsverstärker
- GND: Bezugspotentialanschluß
- IQ: Stromquelle
- K1, K1X: Erster Schaltungsknoten
- K2, K2X: Zweiter Schaltungsknoten
- KL: Klebstoff
- LF: Leadframe
- L1, L1X: Induktivität
- L2, L2X: Weitere Induktivität
- OC: Oszillatorkern
- OS: Oszillatorschaltung
- P: Pin
- P1, P1X: Kontaktstelle
- T1, T1X: Transistor
- TR: Resonanztransformationsschaltung
- US: Steuerspannung
- VCC: Versorgungspotentialanschluß
- VQ: Spannungsquelle

## Patentansprüche

1. Oszillatorschaltung (OS), aufweisend
- einen Oszillatorkern (OC) mit einer ersten Kapazität (D1) und einer zweiten Kapazität (D1X) und mit einer ersten Induktivität (L1) und einer zweiten Induktivität (L1X), die in einem ersten Schaltungsknoten (K1, K1X) mit je einer Kapazität (D1, D1X) verbunden sind und
- einen Entdämpfungsverstärker (EV), der mit dem Oszillatorkern (OC) und mit einer Versorgungsspannungsquelle (VQ), die einen Versorgungs- und einen Bezugspotentialanschluß (GND) hat, gekoppelt ist,
- wobei Oszillatorkern (OC) und Entdämpfungsverstärker (EV) auf einem Halbleiterplättchen (CH), das eine Vorderseite und eine Rückseite hat, integriert sind,
**dadurch gekennzeichnet,**
**daß** die erste und zweite Induktivität (L1, L1X) jeweils als Bonddraht ausgebildet sind und dabei jeweils mit einem ersten Anschluß mit an den ersten Schaltungsknoten (K1, K1X) angeschlossenen Kontaktstellen (P1, P1X) und mit einem zweiten Anschluß mit einem Träger (LF), auf dem das Halbleiterplättchen (CH) mit seiner Rückseite befestigt ist, verbunden sind.

2. Oszillatorschaltung nach Anspruch 1,
**dadurch gekennzeichnet,**
**daß** die erste und zweite Induktivität (L1, L1X) mit ihren zweiten Anschlüssen jeweils an den Bezugspotentialanschluß (GND) der Oszillatorschaltung (OS) angeschlossen sind.

3. Oszillatorschaltung nach Anspruch 1 oder 2,
**dadurch gekennzeichnet,**
**daß** das Halbleiterplättchen (CH) ein p-Substrat hat.

4. Oszillatorschaltung nach einem der Ansprüche 1 bis 3,
**dadurch gekennzeichnet,**
**daß** das Halbleiterplättchen (CH) rückseitig mit einem Klebstoff (KL) auf dem Träger (LF) befestigt ist.

5. Oszillatorschaltung nach einem der Ansprüche 1 bis 4,
**dadurch gekennzeichnet,**
**daß** zur Kopplung von Oszillatorkern (OC) und Entdämpfungsverstärker (EV) eine Resonanztransformationsschaltung (TR) vorgesehen ist, welche ein Paar von an den ersten Schaltungsknoten (K1, K1X) angeschlossenen Koppelkapazitäten (CK, CKX) umfaßt, die in einem zweiten Schaltungsknoten (K2, K2X) an je eine weitere Induktivität (L2, L2X) angeschlossen sind.

6. Oszillatorschaltung nach Anspruch 5,
**dadurch gekennzeichnet,**
**daß** der Entdämpfungsverstärker zumindest einen NMOS-Transistor (T1) aufweist.

7. Oszillatorschaltung nach einem der Ansprüche 1 bis 6,
**dadurch gekennzeichnet,**
**daß** erste und zweite Kapazität (D1, D1X) als Varaktordioden mit spannungsabhängigem Kapazitätswert ausgeführt sind.

8. Oszillatorschaltung nach Anspruch 7,
**dadurch gekennzeichnet,**
**daß** die Varaktordioden (D1, D1X) anodenseitig miteinander verbunden sind und daß anodenseitig eine Steuerspannung (US) zum Einstellen der Kapazitätswerte der Varaktordioden (D1, D1X) zuführbar ist.

9. Oszillatorschaltung nach einem der Ansprüche 1 bis 8,
**dadurch gekennzeichnet,**
**daß** der Oszillatorkern (OC) und die Resonanztransformationsschaltung (TR) symmetrisch ausgebildet sind zur Führung von Differenzsignalen, und daß der Entdämpfungsverstärker (EV) ein Differenzverstärker mit zwei kreuzgekoppelten Transistoren (T1, T1X) ist.

## Claims

1. Oscillator circuit (OS), having
- an oscillator core (OC) having a first capacitance (D1) and a second capacitance (D1X) and having a first inductance (L1) and a second inductance (L1X), which are connected to a respective capacitance (D1, D1X) at a first circuit node (K1, K1X), and
- a deattenuation amplifier (EV), which is coupled to the oscillator core (OC) and to a supply voltage source (VQ) having a supply and a reference-earth potential terminal (GND),
- oscillator core (OC) and deattenuation amplifier (EV) being integrated on a semiconductor chip (CH) having a front side and a rear side,
**characterized**
**in that** the first and second inductances (L1, L1X) are formed in each case as a bonding wire and are in each case connected by a first terminal to contact points (P1, P1X), which are connected to the first circuit node (K1, K1X), and by a second terminal to a carrier (LF), on which the semiconductor chip (CH) is fixed by its rear side.

2. Oscillator circuit according to Claim 1,
**characterized**
**in that** the first and second inductances (L1, L1X) are connected by their second terminals in each case to the reference-earth potential terminal (GND) of the oscillator circuit (OS).

3. Oscillator circuit according to Claim 1 or 2,
**characterized**
**in that** the semiconductor chip (CH) has a p-type substrate.

4. Oscillator circuit according to one of Claims 1 to 3,
**characterized**
**in that** the semiconductor chip (CH) is fixed on the rear side by means of an adhesive (KL) on the carrier (LF).

5. Oscillator circuit according to one of Claims 1 to 4,
**characterized**
**in that** a resonance transformation circuit (TR) is provided for the coupling of oscillator core (OC) and deattenuation amplifier (EV), which resonance transformation circuit comprises a pair of coupling capacitances (CK, CKX), which are connected to the first circuit node (K1, K1X) and are connected to a respective further inductance (L2, L2X) at a second circuit node (K2, K2X).

6. Oscillator circuit according to Claim 5,
**characterized**
**in that** the deattenuation amplifier has at least one NMOS transistor (T1).

7. Oscillator circuit according to one of Claims 1 to 6,
**characterized**
**in that** first and second capacitances (D1, D1X) are embodied as varactor diodes with a voltage-dependent capacitance value.

8. Oscillator circuit according to Claim 7,
**characterized**
**in that** the varactor diodes (D1, D1X) are connected to one another on the anode side, and in that a control voltage (US) for setting the capacitance values of the varactor diodes (D1, D1X) can be fed in on the anode side.

9. Oscillator circuit according to one of Claims 1 to 8,
**characterized**
**in that** the oscillator core (OC) and the resonance transformation circuit (TR) are of symmetrical design for carrying differential signals, and in that the deattenuation amplifier (EV) is a differential amplifier having two cross-coupled transistors (T1, T1X).

## Revendications

1. Circuit (OS) oscillant comprenant
- un noyau (OC) d'oscillateur ayant une première capacité (D1) et une deuxième capacité (D1X) et ayant une première inductance (L1) et une deuxième inductance (L1X) qui sont reliées dans un premier noeud (K1, K1X) de circuit par respectivement une capacité (D1, D1X) et
- un amplificateur (EV) de régénération, qui est couplé au noyau (OC) de l'oscillateur et à une source (VQ) de tension d'alimentation, qui a une borne de potentiel d'alimentation et une borne (GND) de potentiel de référence,
- dans lequel le noyau (OC) de l'oscillateur et l'amplificateur (EV) de régénération sont intégrés sur une plaquette (CH) à semi-conducteurs, qui a une face avant et une face arrière,
**caractérisé en ce que**
la première et la deuxième inductances (L1, L1X) sont constituées respectivement sous la forme d'un fil de liaison et sont reliées respectivement par une première borne aux points (P1, P1X) de contact raccordés aux premiers noeuds (K1, K1X) du circuit et par une deuxième borne à un support (LF) sur lequel la plaquette (CH) à semi-conducteurs est fixée par sa face arrière.

2. Circuit oscillant suivant la revendication 1,
**caractérisé en ce que**
la première et la deuxième inductances (L1, L1X) sont raccordées par leurs deuxièmes bornes respectivement à la borne (GND) de potentiel de référence du circuit (OS) oscillant.

3. Circuit oscillant suivant la revendication 1 ou 2,
**caractérisé en ce que**
la plaquette (CH) à semi-conducteurs a un substrat du type p.

4. Circuit oscillant suivant l'une des revendications 1 à 3,
**caractérisé en ce que**
la plaquette (CH) à semi-conducteurs est fixée par la face arrière au support (LF) par une colle (KL).

5. Circuit oscillant suivant l'une des revendications 1 à 4,
**caractérisé en ce que**
pour le couplage du noyau (OC) de l'oscillateur et de l'amplificateur (EV) de régénération, il est prévu un circuit (TR) de transformation de résonance, qui comprend une paire de capacités (CK, CKX) de couplage raccordée au premier noeud (K1, K1X) de circuit et raccordée dans un deuxième noeud (K2, K2X) de circuit à respectivement une autre inductance (L2, L2X).

6. Circuit oscillant suivant la revendication 5,
**caractérisé en ce que**
l'amplificateur de régénération comporte au moins un transistor (T1) NMOS.

7. Circuit oscillant suivant l'une des revendications 1 à 6,
**caractérisé en ce que**
la première et la deuxième capacité (D1, D1X) sont réalisées en diodes à capacité variable, dont la valeur de la capacité varie en fonction de la tension.

8. Circuit oscillant suivant la revendication 7,
**caractérisé en ce que**
les diodes (D1, D1X) à capacité variable sont reliées entre elles du côté de l'anode et il peut être appliqué du côté de l'anode une tension (US) de commande pour régler les valeurs de capacité des diodes (D1, D1X) à capacité variable.

9. Circuit oscillant suivant l'une des revendications 1 à 8,
**caractérisé en ce que**
le noyau (OC) d'oscillateur et le circuit (TR) de transformation de résonance sont constitués de façon symétrique pour conduire des signaux de différence et **en ce que** l'amplificateur (EV) de régénération est un amplificateur différentiel ayant deux transistors (T1, T1X) rétrocouplés.
